# EUROPEAN PATENT APPLICATION

(11) **EP 4 568 274 A1**
(43) Date of publication of application: **11.06.2025**
(21) Application number: 23937229.5
(22) Date of filing: 23.10.2023
(51) Int. Cl.: H04R 1/10

(54) **EARPHONE**

(30) Priority: 12.05.2023 CN 202310541798
(71) Applicant: Shenzhen Shokz Co., Ltd., Shenzhen, Guangdong 518108 (CN)
(72) Inventor: XIE, Shuailin, Shenzhen, Guangdong 518108 (CN); LIU, Chunjian, Shenzhen, Guangdong 518108 (CN)
(74) Representative: Wang, Bo
(86) International application number: PCT/CN2023/126024
(87) International publication number: WO 2024/234554

(57) **Abstract**

The present disclosure provides an earphone (100) comprising a housing assembly (10), a speaker (11), and an ear hook assembly (12). The housing assembly (10) is provided with a first accommodating cavity (101) and includes a connecting portion (108). The connecting portion (108) is provided with a socket (102) extending along a first direction (F1). The socket (102) includes a first channel (103) and a second channel (104). The first accommodating cavity (101), the first channel (103), and the second channel (104) are sequentially connected, and a first abutment surface (105) is disposed at a transition between the first channel (103) and the second channel (104). The first abutment surface (105) is inclined to the first direction (F1). The speaker (11) is disposed in the first accommodating cavity (101). The ear hook assembly (12) includes a first connecting end (121) that includes a plug portion (126). The plug portion (126) is inserted into the socket (102) and includes a second abutment surface (122) and an annular surface (123), wherein the second abutment surface (123) is inclined to the first direction (F1), the annular surface (123) extends from an inner edge of the second abutment surface (122) toward the first abutment surface (105), and the second abutment surface (122) is disposed to face the first abutment surface (105).

## Description

### CROSS-REFERENCE TO RELATED APPLICATIONS

This application claims priority to Chinese Patent Application No. 202310541798.X, filed on May 12, 2023, entitled "earphones", the entire contents of which are hereby incorporated by reference.

### TECHNICAL FIELD

The present disclosure relates to the field of electronic devices, and in particular relates to button assemblies and earphones.

### BACKGROUND

With the continuous popularization of electronic devices, electronic devices have become indispensable social and entertainment tools in people's daily lives. Electronic devices such as earphones and smart glasses have also been widely used in people's daily lives. The electronic devices may be used in conjunction with cell phones, computers, and other terminal devices to provide an auditory feast for users.

### SUMMARY

The present disclosure provides an earphone. The earphone includes a housing assembly, a speaker, and an ear hook assembly. The housing assembly is provided with a first accommodating cavity and includes a connecting portion. The connecting portion is provided with a socket extending along a first direction. The socket includes a first channel and a second channel. The first accommodating cavity, the first channel, and the second channel are sequentially connected, and a first abutment surface is disposed at a transition between the first channel and the second channel. The first abutment surface is inclined to the first direction. The speaker is disposed in the first accommodating cavity. The ear hook assembly includes a first connecting end that includes a plug portion. The plug portion is inserted into the socket and includes a second abutment surface and an annular surface, wherein the second abutment surface is inclined to the first direction, the annular surface extends from an inner edge of the second abutment surface toward the first abutment surface, and the second abutment surface is disposed to face the first abutment surface.

In some embodiments, the plug portion includes a plug main body portion and a first convex platform extending from the plug main body portion toward the first abutment surface, the plug main body portion includes the second abutment surface, and the first convex platform includes the annular surface. The first convex platform further includes a third abutment surface inclined to the first direction, the third abutment surface being abutted against the first abutment surface.

In some embodiments, the first connecting end further includes a buckle portion. Tthe buckle portion extends from the plug portion into the first accommodating cavity and engages with the housing assembly for buckle fit.

In some embodiments, the buckle portion includes an elastic arm and a locking block. The elastic arm extends from the plug portion and is located within the first channel, the locking block is positioned at an end of the elastic arm and extends laterally with respect to the elastic arm, and the locking block engages with a wall surface of the first accommodating cavity for blocking fit.

In some embodiments, there are two elastic arms and two locking blocks, and the two locking blocks extend away from each other.

In some embodiments, the first abutment surface includes a portion perpendicular to the first direction; and/or the second abutment surface includes a portion perpendicular to the first direction.

In some embodiments, the annular surface extends in a direction parallel to the first direction toward the first abutment surface.

In some embodiments, the ear hook assembly is provided with a through-hole, and at least one of a reinforcement member and a wire is inserted into the through-hole.

In some embodiments, the earphone further comprisesa flexible member, the flexible member being disposed on a periphery of the annular surface and positioned between the second abutment surface and the first abutment surface.

In some embodiments, the speaker is a bone conduction speaker.

In some embodiments, the housing assembly is further configured with a second accommodating cavity, and the earphone further comprises an air conduction speaker disposed in the second accommodating cavity.

In some embodiments, the housing assembly is provided with a pressure relief hole for communicating the second accommodating cavity with an external environment, and the pressure relief hole is configured to extend towards a side where the first accommodating cavity is located.

In some embodiments, the earphone further comprises a button assembly. The button assembly includes a bracket and a button body. The bracket is provided with a hole and an embedding slot located at a periphery of the hole and in communication with the hole, and the button body is disposed on the bracket and includes a main body portion and an embedding portion connected to the main body portion, wherein the main body portion covers the hole, and the embedding portion is embedded in the embedding slot.

In some embodiments, there are multiple embedding slots and multiple embedding portions, and the multiple embedding slots and the multiple embedding portions are arranged at intervals around the hole.

In some embodiments, the bracket includes a plate-shaped portion having a first main surface and a second main surface disposed opposite to each other. The hole and the embedding slot penetrate through the plate-shaped portion along a direction of an interval between the first main surface and the second main surface.

In some embodiments, the main body portion is affixed to the first main surface, and the embedding portion is located on a side surface of the main body portion that is in contact with the first main surface.

In some embodiments, when viewed from a side of the first main surface, the main body portion further covers the embedding slot.

In some embodiments, the button body further includes a button reinforcement portion connected to the embedding portion, the button reinforcement portion being affixed to the second main surface.

In some embodiments, when viewed from a side of the first main surface and/or a side of the second main surface, a slot width of the embedding slot gradually increases in a direction away from the hole.

In some embodiments, along the direction of the interval between the first main surface and the second main surface, a slot width of the embedding slot changes with a depth of the embedding slot.

In some embodiments, the bracket further includes a bracket reinforcement portion disposed on the first main surface and/or the second main surface and located at the periphery of the hole and the embedding slot.

In some embodiments, the bracket reinforcement portion is arranged around the periphery of the hole and the embedding slot.

In some embodiments, a material of the bracket and a material of the button body are a thermoplastic material, a Shore hardness of the button body is less than a Shore hardness of the bracket, and the button body is disposed on the bracket by molding.

In some embodiments, the earphone further comprises a main housing, a sealing cover, and a decorative cover. The main housing is configured to form an accommodating space with at least one open end; the sealing cover is configured to cover the at least one open end and is in sealing cooperation with the main housing; and the decorative cover is connected to the main housing and covers an exterior of the sealing cover.

In some embodiments, the sealing cover and the main housing cooperate with each other to form an annular adhesive groove at a periphery of the sealing cover, and the earphone further comprises a sealing glue filled in the annular adhesive groove.

In some embodiments, an annular support platform is disposed on an inner wall surface of the main housing, the sealing cover is supported on the annular support platform, and the inner wall surface of the main housing located at a side of the annular support platform facing the open end cooperates with an outer wall surface of the sealing cover to form the annular adhesive groove.

In some embodiments, the sealing cover includes a main cover body and an annular flange protruding from an outer wall surface of the main cover body, the annular flange is supported on the annular support platform, and the inner wall surface of the main housing located at the side of the annular support platform facing the open end cooperates with the outer wall surface of the main cover body to form the annular adhesive groove.

In some embodiments, the earphone further comprises an elastic covering layer covering an outer side of the main housing, wherein a portion of the main housing is exposed from the elastic covering layer, and the decorative cover further covers an outer side of the exposed portion of the main housing and is connected to the exposed portion of the main housing.

In some embodiments, the main housing includes a first main side wall, a second main side wall, a first auxiliary side wall, and a second auxiliary side wall. The first main side wall and the second main side wall are spaced apart from each other, the first auxiliary side wall and the second auxiliary side wall are connected to the first main side wall and the second main side wall, and are spaced apart from each other. Aportion of an outer wall surface of the first main side wall and a portion of an outer wall surface of the second main side wall are exposed from the elastic covering layer. The decorative cover covers an outer side of the exposed portion of the outer wall surface of the first main side wall and an outer side of the exposed portion of the outer wall surface of the second main side wall.

In some embodiments, a first snap structure is disposed on each of the exposed portion of the outer wall surface of the first main side wall and the exposed portion of the outer wall surface of the second main side wall, and a second snap structure corresponding to each first snap structure is provided on an inner wall surface of the decorative cover.

In some embodiments, a thickness of a portion of the elastic covering layer covering the outer wall surface of the first main side wall and a thickness of a portion of the elastic covering layer covering the outer wall surface of the second main side wall are the same as a thickness of the decorative cover.

In some embodiments, the earphone further comprises an ear hook located at a side of the first auxiliary side wall and connected to the main housing, and a rear hook located at a side of the second auxiliary side wall and connected to the main housing. The elastic covering layer further covers the ear hook and an outer side of the first auxiliary side wall, and the exposed portion of the outer wall surface of the first main side wall and the exposed portion of the outer wall surface of the second main side wall are closer to the second auxiliary side wall than the first auxiliary side wall.

In some embodiments, a third snap structure and a fourth snap structure corresponding to each other are disposed on the first auxiliary side wall and the decorative cover, respectively.

In some embodiments, the second auxiliary side wall is exposed from the elastic covering layer, and the decorative cover further covers an outer side of the second auxiliary side wall.

### BRIEF DESCRIPTION OF THE DRAWINGS

The present disclosure is further described in terms of exemplary embodiments. These exemplary embodiments are described in detail with reference to the drawings. These embodiments are non-limiting exemplary embodiments, in which like reference numerals represent similar structures throughout the several views of the drawings, and wherein:
FIG. 1 is a diagram of a three-dimensional structure of an earphone according to some embodiments of the present disclosure;
FIG. 2 is a structural diagram of a portion of the earphone shown in FIG. 1;
FIG. 3 is an exploded view of a structure of the portion of the earphone shown in FIG. 2;
FIG. 4 is another exploded view of a structure of the portion of the earphone shown in FIG. 2;
FIG. 5 is a cross-sectional structural diagram of the earphone of FIG. 2 along a D-D cutting direction according to an embodiment of the present disclosure;
FIG. 6 is a cross-sectional structural diagram of the earphone in FIG. 2 along a B-B cutting direction according to an embodiment of the present disclosure;
FIG. 7 is a partially enlarged diagram showing a local structure C of the earphone of FIG. 6;
FIG. 8 is a cross-sectional structural diagram of the earphone of FIG. 2 along a A-A cutting direction according to an embodiment of the present disclosure;
FIG. 9 is another diagram of a three-dimensional structure of an earphone according to an embodiment of the present disclosure;
FIG. 10 is a diagram of a three-dimensional structure of a button assembly according to an embodiment of the present disclosure;
FIG. 11 is an exploded view of a structure of the button assembly shown in FIG. 9.
FIG. 12 is a cross-sectional structural diagram of the button assembly of FIG. 9 along an E-E cutting direction according to an embodiment of the present disclosure;
FIG. 13 is a partially enlarged diagram showing a local structure F of the button assembly shown in FIG. 10 according to an embodiment of the present disclosure;
FIG. 14 is a cross-sectional structural diagram of the button assembly in FIG. 9 along a G-G cutting direction according to an embodiment of the present disclosure;
FIG. 15 is a structural diagram of another portion of the earphone shown in FIG. 1;
FIG. 16 is an exploded view of a structure of a portion of the earphone shown in FIG. 14;
FIG. 17 is a cross-sectional structural diagram of the earphone shown in FIG. 14 along an O-O cutting direction according to an embodiment of the present disclosure; and
FIG. 18 is another exploded view of a structure of a portion of the earphone shown in FIG. 14.

### DETAILED DESCRIPTION

The present disclosure is described in further detail below in conjunction with the accompanying drawings and embodiments. In particular, it should be noted that the following embodiments are only used to illustrate the present disclosure, but do not limit the scope of the present disclosure. Similarly, the following embodiments are only some but not all embodiments of the present disclosure, and all other embodiments obtained by a person of ordinary skill in the art without creative labor fall within the scope of protection of the present disclosure.

References to "embodiments" in the present disclosure mean that particular features, structures, or characteristics described in conjunction with embodiments may be included in at least one embodiment of the present disclosure. It should be understood by those of skill in the art, both explicitly and implicitly, that the embodiments described in the present disclosure may be combined with other embodiments.

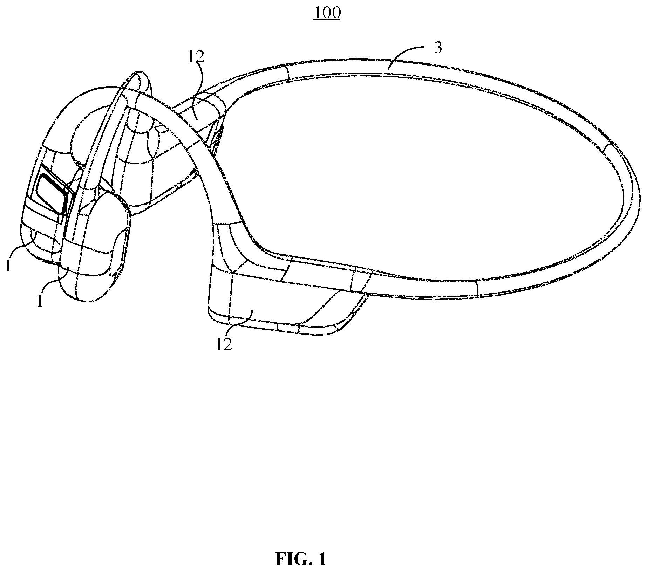

The present disclosure provides an earphone 100, as shown in FIG. 1. FIG. 1 is a general assembly diagram of the earphone 100 of the present disclosure. The earphone 100 includes a core assembly 1, an ear hook assembly 12, and a rear hook 3. In this embodiment, there are two core assemblies 1. The two core assemblies 1 are configured to transmit vibration and/or sound to the left ear and the right ear of a user, respectively, and the two core assemblies 1 may be the same or different. For example, one of the two core assemblies 1 may be provided with a microphone, and the other core assembly 1 may not be provided with a microphone. As another example, one of the two core assemblies 1 may be provided with a key and a corresponding circuit board, and the other core assembly 1 may not be provided with the key and the corresponding circuit board. The two core assemblies 1 may be identical on a core module (e.g., a speaker module). There are two ear hook assemblies 12, and the two ear hook assemblies 12 may be hung on the left ear and the right ear of the user, respectively, such that the two core assemblies 1 may fit the face of the user. One of the two ear hook assemblies 12 may be provided with a battery, and the other ear hook assembly 12 may be provided with a control circuit, or the like. One end of the ear hook assembly 12 is connected to the core assembly 1, and another end of the ear hook assembly 12 is connected to the rear hook 3. The rear hook 3 connects the two ear hook assemblies 12, and the rear hook 3 is configured to wrap around a rear side of the neck of the user or a rear side of the head of the user, and provide a clamping force, such that the two core assemblies 1 are clamped to two sides of the face of the user, and the ear hook assemblies 12 hang more securely to the ears of the user.

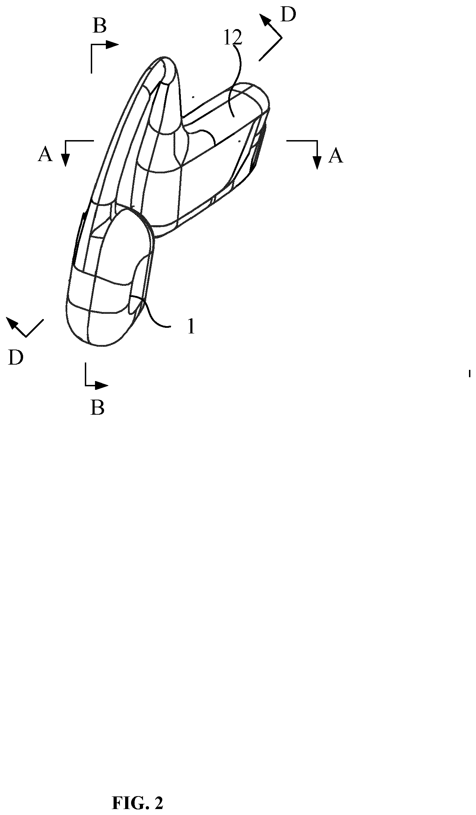

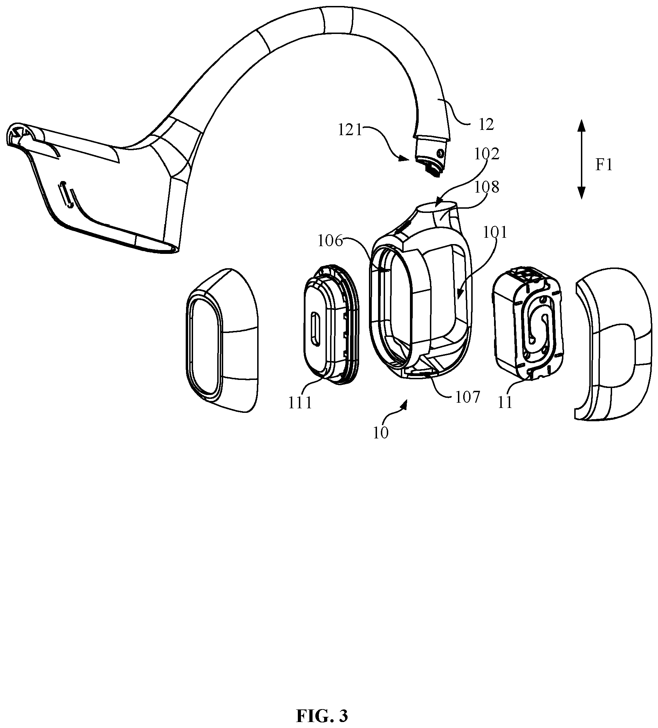

In some embodiments, as shown in FIG. 2 and FIG. 3, the earphone 100 of the present disclosure includes a housing assembly 10, a speaker 11, and the ear hook assembly 12. Optionally, the core assembly 1 includes the housing assembly 10 and the speaker 11.

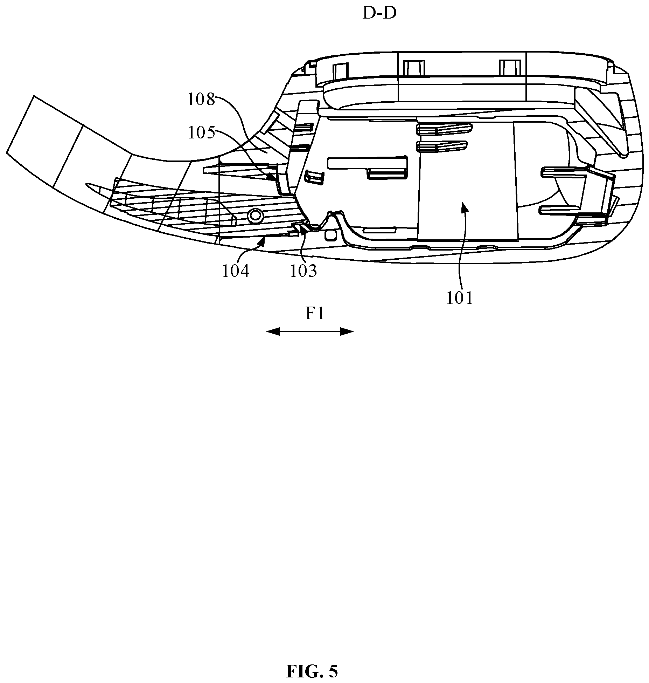

Optionally, as shown in FIG. 3 to FIG. 7, the housing assembly 10 is provided with a first accommodating cavity 101 and includes a connecting portion 108. The connecting portion 108 is provided with a socket 102 extending along a first direction F1. The socket 102 includes a first channel 103 and a second channel 104. The first accommodating cavity 101, the first channel 103, and the second channel 104 are sequentially connected. A first abutment surface 105 is disposed at a transition between the first channel 103 and the second channel 104, and the first abutment surface 105 is inclined to the first direction F1. The speaker 11 is provided in the first accommodating cavity 101. The ear hook assembly 12 includes a first connecting end 121. The first connecting end 121 includes a plug portion 126, the plug portion 126 is inserted into the socket 102, and includes a second abutment surface 122 and an annular surface 123. The second abutment surface 122 is inclined to the first direction F1, the annular surface 123 extends from an inner edge of the second abutment surface 122 toward the first abutment surface 105, and the second abutment surface 122 is disposed to face the first abutment surface 105.

In the related technology, since the speaker 11 is usually a bone conduction speaker, the size of the speaker 11 is relatively large, and the speaker 11 needs to be installed in the housing assembly 10, and connected with a wire. If the ear hook assembly 12 is first inserted and connected to the housing assembly 10, and then sealed by dispensing using glue, in order to prevent the glue from touching the speaker 11, the speaker 11 needs to be moved before dispensing the glue. After dispensing the glue, it is necessary to reorganize the wire connected to the speaker 11, so the production and assembly efficiency of this approach is low. Compared to the related technology, in the present disclosure, by providing the connecting portion 108, forming the socket 102 (which includes the first channel 103 and the second channel 104) in the connecting portion 108, and providing the plug portion 126 for inserting into the socket 102 on the ear hook assembly 12, thereby achieving an easier connection between the ear hook assembly 12 and the housing assembly 10, reducing the impact on the speaker 11 that was previously installed within the housing assembly 10, and thus improving production and assembly efficiency. More specifically, by providing the second abutment surface 122 and the annular surface 123 on the plug portion 126, glue may be applied first to the second abutment surface 122 and the annular surface 123. The plug portion 126 is then inserted into the socket 102, allowing the glue to bond between the second abutment surface 122 and the first abutment surface 105, thereby adhesively connecting the ear hook assembly 12 with the housing assembly 10. Additionally, an annular gap may be formed between the first abutment surface 105, the second abutment surface 122, and the annular surface 123. Once the glue within the annular gap cures, it can serve as an annular seal, thereby enhancing the stability and sealing of the connection between the ear hook assembly 12 and the housing assembly 10, effectively sealing a gap between the plug portion 126 and the connecting portion 108, significantly reducing the likelihood of moisture entering an interior of the earphone 100 through the gap between the plug portion 126 and the connecting portion 108, reducing the chances of a circuitry and other functional components inside the earphone 100 becoming damp, and contributing to an extended service life of the earphone 100. Furthermore, compared to other connection techniques, the plug-in connection enhances connection stability while avoiding the need to add extra matching structures on external surfaces of the ear hook assembly 12 and the housing assembly 10, thereby improving the aesthetic appeal of the earphone 100. Moreover, the connection made by inserting the plug portion 126 into the socket 102 effectively reduces assembly complexity, thereby improving assembly efficiency.

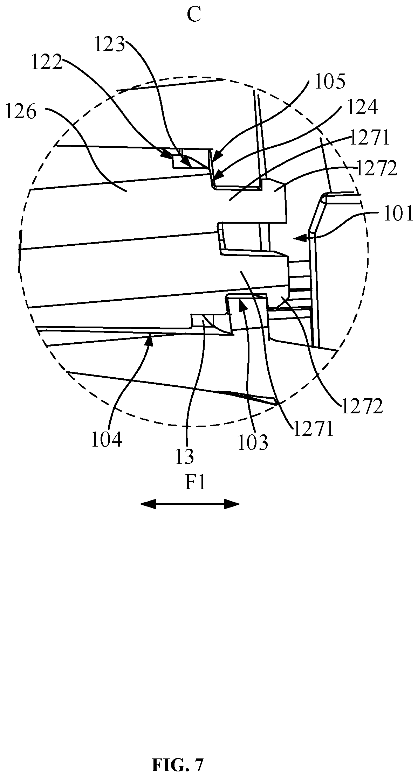

Optionally, as shown in FIG. 7, the earphone 100 further includes a flexible member 13. The flexible member 13 is disposed on the periphery of the annular surface 123 and positioned between the second abutment surface 122 and the first abutment surface 105. It is noted here that the flexible member 13 is the structure formed by the cured glue within the annular gap between the first abutment surface 105, the second abutment surface 122, and the annular surface 123. The structure not only bonds the plug portion 126 and the connecting portion 108 but also forms a seal between the plug portion 126 and the connecting portion 108, thereby enhancing the sealing between the ear hook assembly 12 and the housing assembly 10. The structure effectively seals the gap between the plug portion 126 and the connecting portion 108 and significantly reduces the likelihood of moisture entering the interior of the earphone 100 through the gap between the plug portion 126 and the connecting portion 108, which reduces the chances of the circuitry and other functional components inside the earphone 100 becoming damp, thereby improving the waterproof performance of the earphone 100 and extending the service life of the earphone 100.

In some embodiments, the flexible member 13 is a sealant. When dispensing the sealant, it might initially be in a fluid form and may cure over time. Without the gap between the first abutment surface 105, the second abutment surface 122, and the annular surface 123, and if the sealant needs to be applied between the plug portion 126 and the connecting portion 108, the process may involve dispensing the sealant first and then inserting and installing the first connecting end 121 of the ear hook assembly 12. During the insertion and installation of the first connecting end 121, the plug portion 126 may push the sealant into the first accommodating cavity 101, affecting the normal operation of the earphone 100. By setting the first abutment surface 105, the second abutment surface 122, and the annular surface 123 to form the gap, the sealant may be accommodated in the gap, thus effectively reducing the possibility of the sealant being forced into the first accommodating cavity 101 by the plug portion 126 and minimizing adverse effects on the operation of the earphone 100.

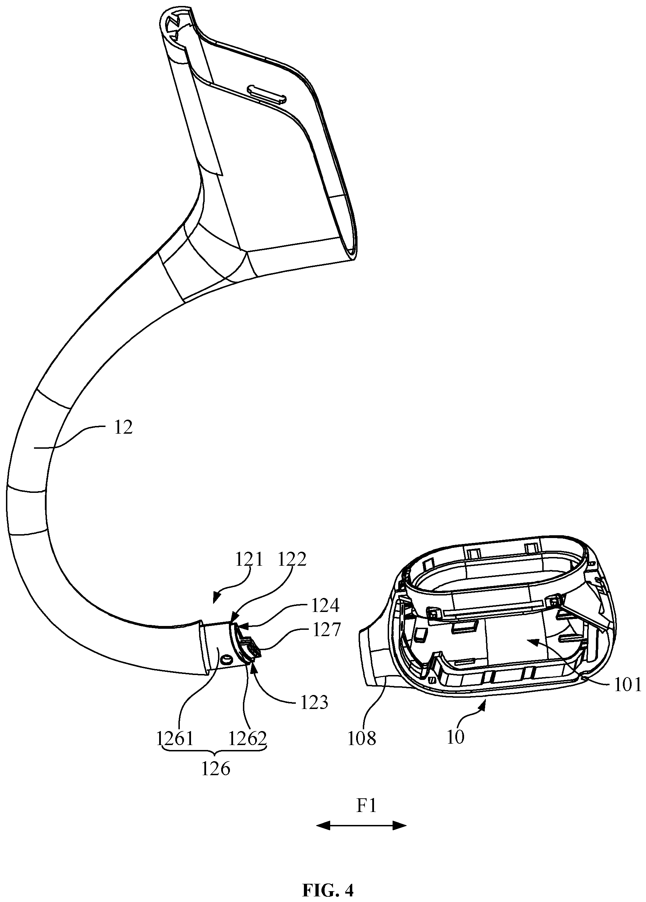

Optionally, as shown in FIG. 4, the plug portion 126 includes a plug main body 1261 and a first convex platform 1262 extending from the plug main body 1261 toward the first abutment surface 105. The plug main body 1261 includes the second abutment surface 122, and the first convex platform 1262 includes the annular surface 123. The first convex platform 1262 also includes a third abutment surface 124 inclined to the first direction F1, and the third abutment surface 124 abuts against the first abutment surface 105.

By providing the first convex platform 1262 extending from the plug main body 1261 toward the first abutment surface 105 to form the annular surface 123 and the first convex platform 1262 includes the third abutment surface 124, thus the third abutment surface 124 abuts against the first abutment surface 105 to further secure the positioning of the plug portion 126, and enhance the connection stability and sealing between the ear hook assembly 12 and the housing assembly 10. The arrangement of the first convex platform 1262 allows a gap to be formed between the first abutment surface 105 and the second abutment surface 122, which may accommodate the sealant, thereby improving the connection stability and sealing between the ear hook assembly 12 and the housing assembly 10, and contributing to extending the service life of the earphone 100. Furthermore, the third abutment surface 124, the annular surface 123, and the second abutment surface 122 are arranged in a stepped shape, and the third abutment surface 124 is inclined towards the first direction F1, which effectively guides the plug portion 126 to insert into the socket 102, thereby facilitating positioning, effectively reducing assembly difficulty, and improving assembly efficiency.

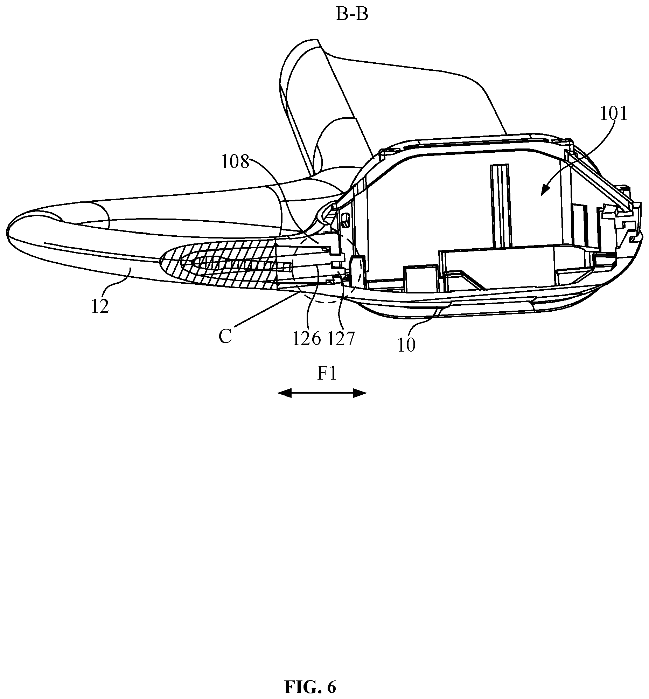

Optionally, as shown in FIG. 4 and FIG. 6, the first connecting end 121 further includes a buckle portion 127. The buckle portion 127 extendes from the plug portion 126 into the first accommodating cavity 101 and engages with the housing assembly 10 for buckle fit. Where the plug portion 126 includes the plug main body 1261 and the first convex platform 1262, the buckle portion 127 extends from the first convex platform 1262 of the plug portion 126 into the first accommodating cavity 101.

By providing the buckle portion 127 that extends from the plug portion 126 into the first accommodating cavity 101 to snap fit with the housing assembly 10, the connection stability and reliability of the first connecting end 121 of the ear hook assembly 12 with the housing assembly 10 are further enhanced, thereby effectively improving the stability and reliability of the connection between the ear hook assembly 12 and the core assembly 1, and effectively improving the service life of the earphone 100.

Optionally, as shown in FIG. 7, the buckle portion 127 includes an elastic arm 1271 and a locking block 1272. The elastic arm 1271 extends from the plug portion 126 and is located within the first channel 103. The locking block 1272 is positioned at an end of the elastic arm 1271 and extends laterally with respect to the elastic arm 1271, and the locking block 1272 engages with a wall surface of the first accommodating cavity 101 for blocking fit.

By providing the elastic arm 1271, the plug portion 126 can be inserted into the second channel 104, and the elastic arm 1271 can be inserted into the first channel 103, thereby enhancing the connection stability and reliability between the ear hook assembly 12 and the housing assembly 10. The elastic arm 1271 may undergo elastic deformation within a certain range, which helps reduce assembly and disassembly difficulty. Moreover, setting the locking block 1272 can further limit and secure the elastic arm 1271. The blocking fit between the locking block 1272 and the wall surface of the first accommodating cavity 101 restricts movement of the elastic arm 1271 in the first direction F1, thereby reducing the possibility of the elastic arm 1271 dislodging from the first channel 103. This arrangement enhances the connection stability and reliability between the ear hook assembly 12 and the housing assembly 10, thus extending the service life of the earphone 100.

Optionally, as shown in FIG. 7, there are two elastic arms 1271 and two locking blocks 1272, and the two locking blocks 1272 extend in opposite directions.

By setting the two elastic arms 1271 and the corresponding two locking blocks 1272, a contact area between the buckle portion 127 and the housing assembly 10 is effectively increased, thereby improving the connection stability and reliability between the buckle portion 127 and the housing assembly 10. Additionally, configuring the two locking blocks 1272 to extend in opposite directions can improve the effect of the blocking fit between the locking block 1272 and the wall surface of the first accommodating cavity 101 and balance forces applied to the two locking blocks 1272, thereby contributing to extending the service life of the earphone 100.

Optionally, in some embodiments, the first abutment surface 105 includes a portion perpendicular to the first direction F1. In some embodiments, the second abutment surface 122 includes a portion perpendicular to the first direction F1. In other embodiments, the first abutment surface 105 includes a portion perpendicular to the first direction F1, and the second abutment surface 122 includes a portion perpendicular to the first direction F1.

By setting the first abutment surface 105 and the second abutment surface 122 to include portions perpendicular to the first direction F1, it facilitates better accommodation of the sealant, thereby enhancing sealing and connection stability.

Optionally, as shown in FIG. 7, the annular surface 123 extends in a direction parallel to the first direction F1 toward the first abutment surface 105.

By configuring the annular surface 123 to extend in the direction parallel to the first direction F1 toward the first abutment surface 105, the plug portion 126 is effectively guided into the socket 102, thereby facilitating positioning, reducing assembly difficulty, and improving assembly efficiency. The annular surface 123 does not adhere to an inner wall of the second channel 104, which allows for accommodation of the sealant, thereby improving sealing and connection stability.

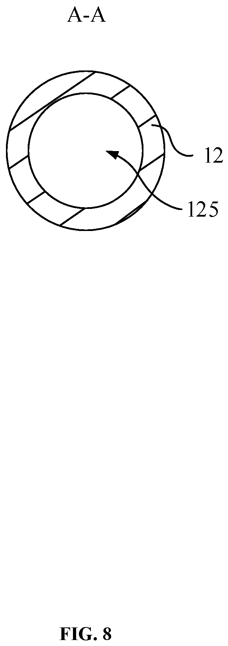

Optionally, as shown in FIG. 8, the ear hook assembly 12 is provided with a through-hole 125, and at least one of a reinforcement member and a wire is inserted into the through-hole 125. In some other embodiments, there are two through-holes 125, and the reinforcing member and the wire are inserted into the two through-holes 125, respectively.

By providing the ear hook assembly 12 with the through-hole 125, the reinforcing member and/or the wire can be inserted into the through-hole 125 without being exposed to the earphone 100, which is conducive to enhancing the aesthetics of the earphone 100. In addition, providing the ear hook assembly 12 with the through-hole 125 to accommodate the wire can enhance the space utilization of the earphone 100, and providing the reinforcing member in the through-hole 125 can enhance the supportability of the ear hook assembly 12 for easy attachment to the ear of the user, which can achieve both wearing comfort and wearing stability, thereby improving the sense of use of the earphone 100.

Optionally, as shown in FIG. 3, the speaker 11 within the core assembly 1 is a bone conduction speaker. Optionally, the housing assembly 10 is further provided with a second accommodating cavity 106, and the earphone 100 further comprises an air conduction speaker 111 disposed in the second accommodating cavity 106.

The air conduction speaker 111 is a speaker assembly that transmits sound to the user through the principle of air vibration, while the bone conduction speaker is a speaker assembly that transmits sound to the user by simulating sound vibration frequencies for bone conduction vibration. The first accommodating cavity 101 and the second accommodating cavity 106 may be isolated from each other, with the sealing of the first accommodating cavity 101 being greater than the sealing of the second accommodating cavity 106. The bone conduction speaker is disposed in the first accommodating cavity 101, and the air conduction speaker 111 is disposed in the second accommodating cavity 106. In some embodiments, the first accommodating cavity 101 is set to be completely sealed, while the second accommodating cavity 106 is set to be a highly sealed accommodating cavity, ensuring a sound-producing condition of the air conduction speaker 111. This arrangement allows separate installation of the bone conduction speaker and the air conduction speaker 111, thereby effectively enhancing the sealing effect of the bone conduction speaker, and preventing the bone conduction speaker from being eroded and damaged by external environmental factors, while ensuring the sound quality of the air conduction speaker 111. Furthermore, when the bone conduction speaker and the air conduction speaker 111 of the earphone 100 operate simultaneously, as the bone conduction speaker and the air conduction speaker 111 are separately placed in the first accommodating cavity 101 and the second accommodating cavity 106, respectively, mutual interference between them can be effectively prevented, thereby significantly improving the sound quality of the earphone 100.

Optionally, as shown in FIG. 3, the housing assembly 10 is provided with a pressure relief hole 107 for communicating the second accommodating cavity 106 with an external environment, and the pressure relief hole 107 is configured to extend towards a side where the first accommodating cavity 101 is located.

The bone conduction speaker and the air conduction speaker 111 are accommodated in the first accommodating cavity 101 and the second accommodating cavity 106, respectively. The housing assembly 10 is provided with the pressure relief hole 107 to relieve pressure for the air conduction speaker 111. The pressure relief hole 107 is configured to communicate the second accommodating cavity 106 with the external environment, and the pressure relief hole 107 is configured to extend towards a side where the first accommodating cavity 101 is located. This configuration effectively reduces the space occupied by the pressure relief hole 107 on a periphery of the second accommodating cavity 106, which utilizes the space between the first accommodating cavity 101 and the second accommodating cavity 106 more efficiently, thereby improving the space utilization of the housing assembly 10, such that the housing assembly 10 can be arranged in a more compact and reasonable manner while meeting the sound-producing condition of the air conduction speaker 111.

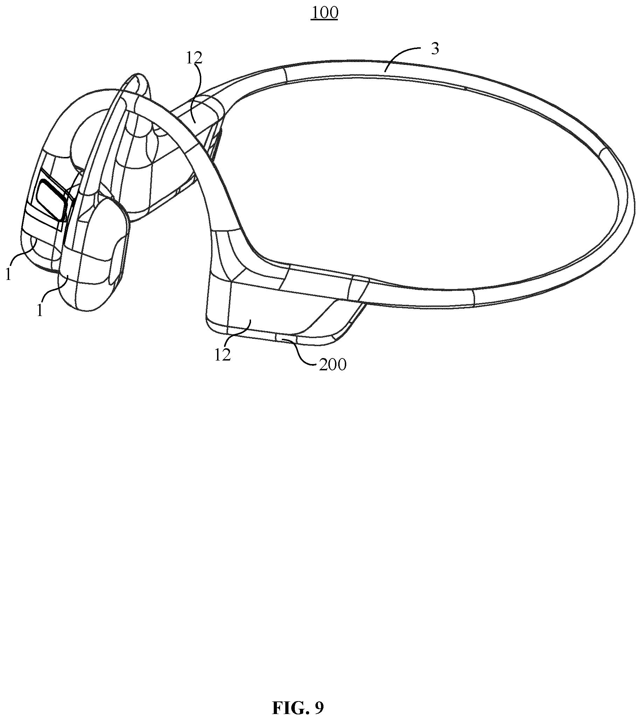

As previously described, the earphone 100 includes the ear hook assembly 12. As shown in FIG. 9, in some embodiments, the ear hook assembly 12 may include a button assembly 200.

In some embodiments, a circuit board may be provided within the ear hook assembly 12. The circuit board is configured to convert and process electrical signals to support the implementation of various functions of the earphone 100. The button assembly 200 may be configured to receive the user's press and move relative to the circuit board, thereby triggering the circuit board to operate. For example, the button assembly 200 may move or undergo elastic deformation in response to the user's press, thereby triggering the circuit board to perform functions such as turning on or off the earphone 100, switching playback content, and increasing or decreasing a sound volume, etc. In some embodiments, a battery may be provided within the earphone 100. In some embodiments, the battery is provided within one of the two ear hook assemblies 12, and the circuit board is provided within the other one of the two ear hook assemblies 12.

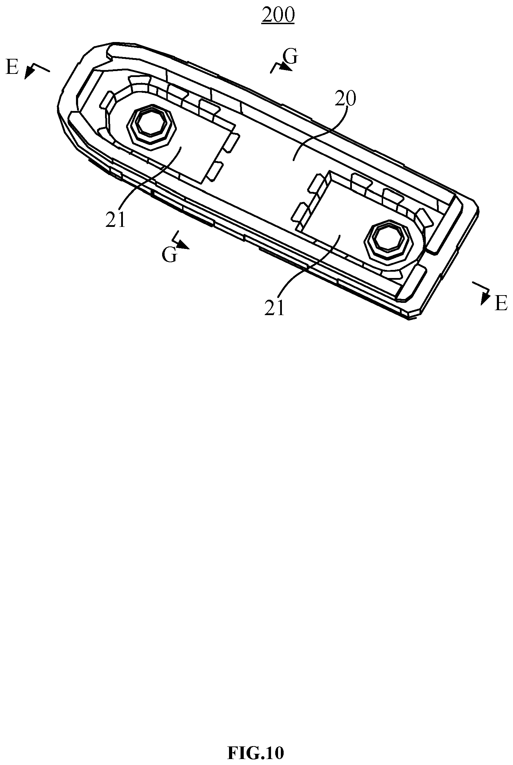

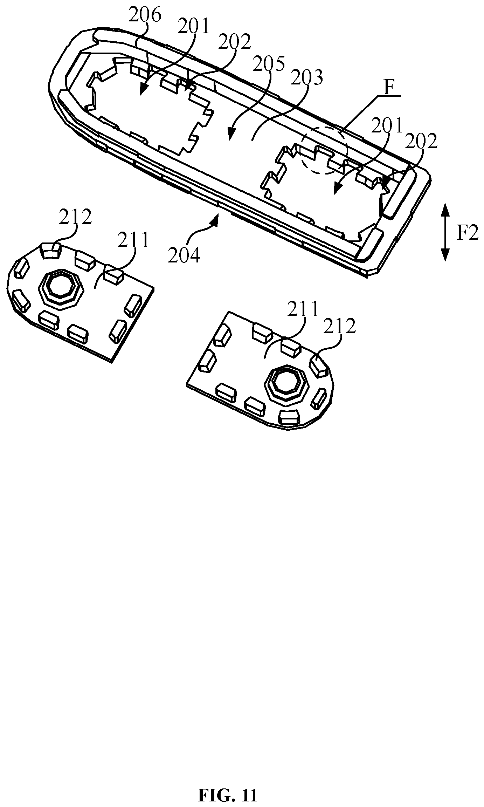

Optionally, as shown in FIG. 10 and FIG. 11, the button assembly 200 includes a bracket 20 and a button body 21. The bracket 20 is provided with a hole 201 and an embedding slot 202 located at a periphery of the hole 201 and in communication with the hole 201. The button body 21 is disposed on the bracket 20 and includes a main body portion 211 and an embedding portion 212 connected to the main body portion 211. The main body portion 211 covers the hole 201, and the embedding portion 212 is embedded in the embedding slot 202.

By configuring the button assembly 200 including the bracket 20 and the button body 21, with the button body 21 disposed on the bracket 20, and the hole 201 formed on the bracket 20 covered by the main body portion 211 of the button body 21, the arrangement allows the button body 21 to trigger the circuit board inside the ear hook 2 when pressed by the user. The bracket 20 provides support for the button body 21, thereby reducing a potential impact of the user's press on other internal components of the earphone 100. Additionally, if the button body 21 is damaged, the button body 21 only needs to be replaced separately, thereby facilitating the repair and maintenance of the earphone 100 and effectively reducing repair costs. By providing the bracket 20 with the embedding slot 202 and providing the button body 21 with the embedding portion 212, the connection between the button body 21 and the bracket 20 is achieved through the cooperation of the embedding portion 212 and the embedding slot 202. This ensures the stability of the connection between the bracket 20 and the button body 21 without the need for glue, an adhesive, or the like, thus preventing the glue, the adhesive, or the like from sticking on a surface of the earphone 100, which may affect the aesthetic appearance of the earphone 100. This is beneficial for enhancing the aesthetic appearance of the earphone 100.

Optionally, as shown in FIG. 10 and FIG. 11, there are multiple embedding slots 202 and multiple embedding portions 212, and the multiple embedding slots 202 and the multiple embedding portions 212 are arranged at intervals around the hole 201.

By configuring the multiple embedding slots 202 and the multiple embedding portions 212 to cooperate, the connection between the bracket 20 and the button body 21 is effectively enhanced, thereby increasing a contact area between the bracket 20 and the button body 21 and improving connection stability and reliability. Additionally, arranging the multiple embedding slots 202 and the multiple embedding portions 212 at intervals around the hole 201 ensures more balanced force distribution, thereby extending the service life of the button assembly 200 and the earphone 100.

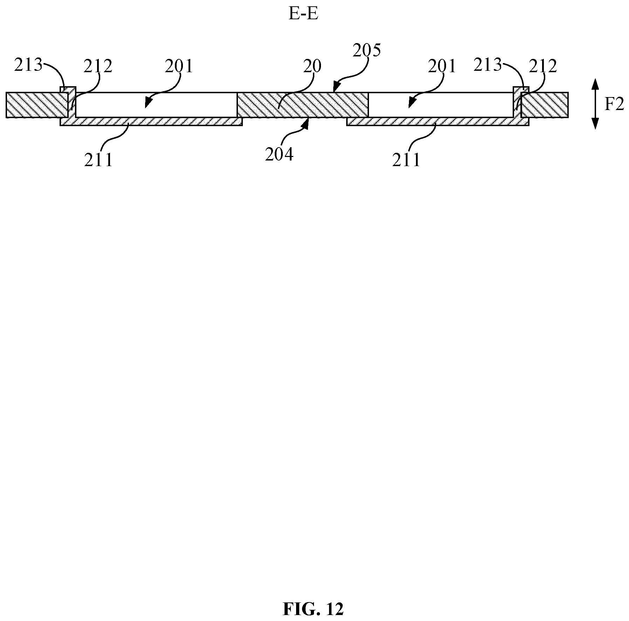

Optionally, as shown in FIG. 11 and FIG. 12, the bracket 20 includes a plate-shaped portion 203. The plate-shaped portion 203 has a first main surface 204 and a second main surface 205 that are arranged away from each other. The hole 201 and the embedding slot 202 penetrate through the plate-shaped portion 203 along a direction F2 of an interval between the first main surface 204 and the second main surface 205.

By providing the hole 201 that penetrates through the plate-shaped portion 203, the user can press the button body 21 to trigger the circuit board inside the earphone 100 to perform corresponding functions. Moreover, the plate-shaped portion 203 provides support, preventing the user's press from affecting other internal parts of the earphone 100, thus ensuring the reliability and stability of the operation of the earphone 100. Additionally, setting the embedding slot 202 to extend through the plate-shaped portion 203 can further increase a contact area between the embedding portion 212 and the embedding slot 202, thereby effectively enhancing the connection stability and reliability between the button body 21 and the bracket 20.

Optionally, as shown in FIG. 12, the main body portion 211 is affixed to the first main surface 204, and the embedding portion 212 is located on a side surface of the main body portion 211 that is in contact with the first main surface 204.

By providing the embedding portion 212 on the side surface of the main body portion 211 that is in contact with the first main surface 204, it is conducive to lowering the assembly difficulty and enhancing the space utilization of the button assembly 200.

Optionally, as shown in FIG. 11 and FIG. 12, when viewed from a side of the first main surface 204, the main body portion 211 further covers the embedding slot 202.

By configuring the main body portion 211 to cover the embedding slot 202 when viewed from the side of the first main surface 204, the possibility of the embedding portion 212 and the embedding slot 202 being exposed to the external environment is effectively reduced, thereby enhancing the aesthetic appearance of the earphone 100, reducing the possibility of the embedding portion 212 and the embedding slot 202 being damaged by external factors, effectively reducing the possibility of exposing the internal components of earphone 100 to the outside world, and extending the service life of the earphone 100.

Optionally, as shown in FIG. 12, the button body 21 further includes a button reinforcement portion 213 connected to the embedding portion 212. The button body reinforcement portion 213 is affixed to the second main surface 205.

By providing the button reinforcement portion 213 affixed to the second main surface 205, it is possible to further limit the embedding portion 212, and effectively enhance the connection stability between the embedding portion 212 and the embedding slot 202, thereby further enhancing the connection stability and reliability between the button body 21 and the bracket 20.

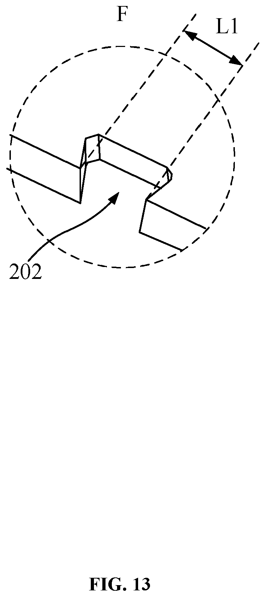

Optionally, as shown in FIG. 13, when viewed from the side of the first main surface 204 and/or a side of the second main surface 205, a slot width L1 of the embedding slot 202 gradually increases in a direction away from the hole 201. The slot width L1 of the embedding slot 202 is a width between two opposing slot walls that form the embedding slot 202.

By configuring the slot width L1 of the embedding slot 202 to gradually increase in the direction away from the hole 201, the contact area between the embedding portion 212 and the embedding slot 202 is effectively increased, thereby effectively enhancing the connection stability between the embedding portion 212 and the embedding slot 202, and effectively improving the stability and reliability of the connection between the button body 21 and the bracket 20.

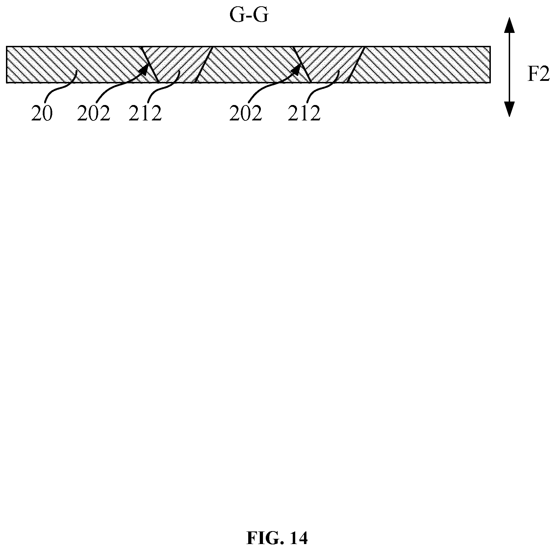

Optionally, as shown in FIG. 14, along the direction F2 of the interval between the first main surface 204 and the second main surface 205, the slot width L1 of the embedding slot 202 changes with the depth of the embedding slot 202.

By configuring the slot width L1 of the embedding slot 202 to change with the depth of the embedding slot 202, the contact area between the embedding portion 212 and the embedding slot 202 is effectively increased, thereby effectively enhancing the connection stability between the embedding portion 212 and the embedding slot 202, which further effectively improves the stability and reliability of the connection between the button body 21 and the bracket 20. In some embodiments, the slot width L1 of the embedding slot 202 close to the first main surface 204 is greater than the slot width L1 of the embedding slot 202 close to the second main surface 205. In some embodiments, the slot width L1 of the embedding slot 202 close to the second main surface 205 is greater than the slot width L1 of the embedding slot 202 close to the first main surface 204. In some embodiments, the slot width L1 of the embedding slot 202 close to the first main surface 204 and the slot width L1 of the embedding slot 202 close to the second main surface 205 are both greater than the slot width L1 of a middle portion of the embedding slot 202.

Optionally, as shown in FIG. 11, the bracket 20 further includes a bracket reinforcement portion 206 disposed on the first main surface 204 and/or the second main surface 205 and located at the periphery of the hole 201 and the embedding slot 202.

By providing the bracket reinforcement portion 206, the support and strength of the bracket 20 are enhanced, which not only improves the user's experience with the button assembly 200, but also also extends the service life of the bracket 20, thereby prolonging the service life of the button assembly 200 and, consequently, extending the service life of the earphone 100.

Optionally, as shown in FIG. 11, the bracket reinforcement portion 206 is arranged around the periphery of the hole 201 and the embedding slot 202.

By arranging the bracket reinforcement portion 206 to around the periphery of the hole 201 and the embedding slot 202, the support and strength of the bracket 20 are enhanced without hindering the user from pressing or using the button body 21. This arrangement also reduces the likelihood of the user's press on the button body 21 affecting other components of the earphone 100.

Optionally, a material of the bracket 20 and a material of the button body 21 are both a thermoplastic. The Shore hardness of the button body 21 is less than the Shore hardness of the bracket 20, and the button body 21 is disposed in the bracket 20 in a molding manner.

By setting the material of the button body 21 and the material of the bracket 20 as the thermoplastic, the button body 21 can be disposed in the bracket 20 in a molding manner. The molding manner may include a two-color injection molding manner, etc., which is conducive to improving a degree of fit of a contact surface between the button body 21 and the bracket 20, thereby effectively improving the stability and reliability of the connection between the button body 21 and the bracket 20. The Shore hardness of the button body 21 is less than the Shore hardness of the bracket 20. By reasonably configuring the Shore hardness of the button body 21 and the Shore hardness of the bracket 20, the support of the bracket 20 and the elasticity of the button body 21 can be ensured at the same time. This configuration allows the user to press the button body 21 to trigger the functions of the earphone 100 without impacting other internal components of the earphone 100, thereby enhancing user experience and extending the service life of the earphone 100. In some embodiments, the material of the button body 21 may include polyethylene terephthalate (PET), thermoplastic polyurethane elastomer (TPU), thermoplastic elastomer (TPE), or the like, and the material of the bracket 20 may include polycarbonate (PC), or the like.

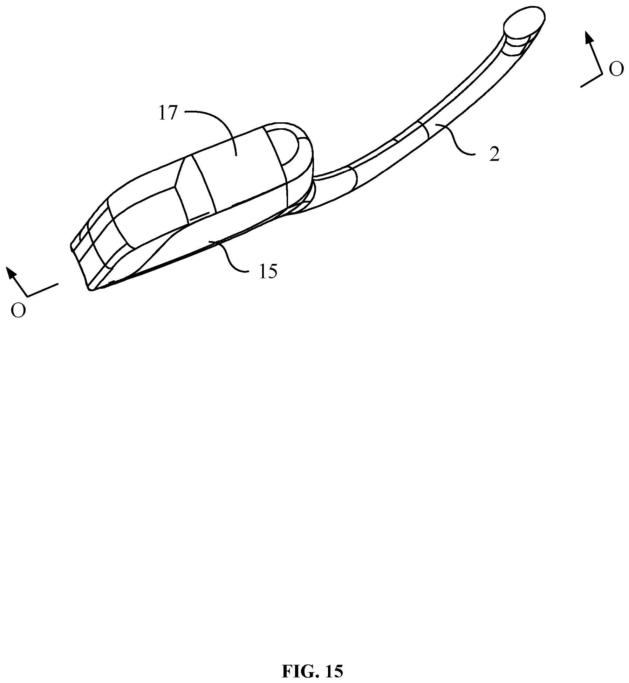

In some embodiments, as shown in FIG. 15, the earphone 100 may include a main housing 15, a sealing cover 16, and a decorative cover 17.

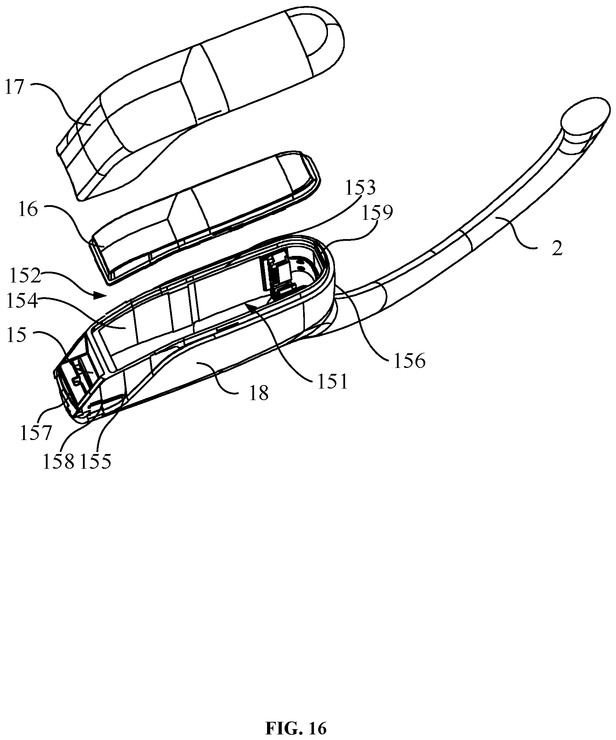

Optionally, as shown in FIG. 16, the main housing 15 is configured to form an accommodating space 151 with at least one open end 152. The sealing cover 16 is configured to cover the at least one open end 152 and is in sealing cooperation with the main housing 15. The decorative cover 17 is connected to the main housing 15 and covers an exterior of the sealing cover 16.

By configuring the sealing cover 16 to cooperate with the main housing 15, the at least one open end 152 is sealed to seal the accommodating space 151, thereby effectively reducing the possibility of external dust or moisture entering the accommodating space 151, and thus effectively reducing the possibility of damage or moisture to the parts accommodated in the accommodating space 151, which is beneficial for improving the service life of the earphone 100. Furthermore, by disposing the decorative cover 17 which covers the exterior of the sealing cover 16 and is connected to the main housing 15, the sealing of the earphone 100 can be maintained while significantly enhancing the aesthetic appearance of the earphone 100, thereby improving user experience. In addition, providing the sealing cover 16 and the decorative cover 17 allows the earphone 100 to be sealed in a visible environment during assembly, thereby reducing assembly difficulty and increasing assembly efficiency and yield rate. The decorative cover 17 covering the sealing cover 16 significantly enhances the aesthetic value of the earphone 100, achieving both sealing and attractiveness of the earphone 100.

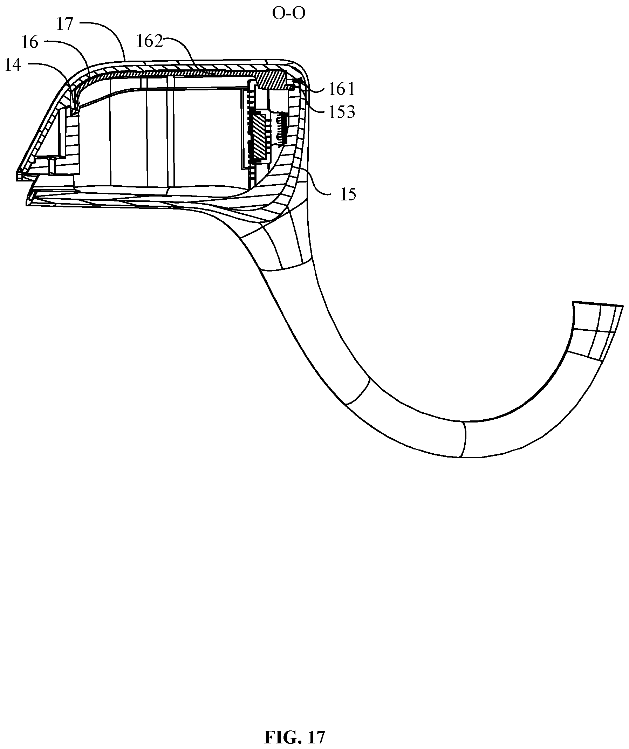

Optionally, as shown in FIG. 17, the sealing cover 16 and the main housing 15 cooperate with each other to form an annular adhesive groove 161 at the periphery of the sealing cover 16, and the earphone 100 further includes a sealing glue 14 filled in the annular adhesive groove 161.

By setting the annular adhesive groove 161 at the periphery of the sealing cover 16 and filling the sealing glue 14 in the annular adhesive groove 161, a gap between the sealing cover 16 and the main housing 15 can be effectively filled. The annular adhesive groove achieves comprehensive circular sealing, further enhancing the sealing and connection stability between the sealing cover 16 and the main housing 15. Additionally, the configuration of the annular adhesive groove 161 effectively minimizes the possibility of overflow of the sealing glue 14, allowing the filling of the sealing glue 14 to be performed in a visible environment, which reduces the assembly difficulty and improves the assembly efficiency and yield rate.

Optionally, as shown in FIG. 16 and FIG. 17, an annular support platform 153 is disposed on an inner wall surface of the main housing 15. The sealing cover 16 is supported on the annular support platform 153, and the inner wall surface of the main housing 15 located at a side of the annular support platform 153 facing the open end 152 cooperates with an outer wall surface of the sealing cover 16 to form the annular adhesive groove 161.

By arranging an annular support platform 153 to support the sealing cover 16, the installation and positioning of the sealing cover 16 are facilitated, thereby enhancing the connection stability and reliability between the sealing cover 16 and the main housing 15. Additionally, the inner wall surface of the main housing 15 located at the side of the annular support platform 153 facing the open end 152 cooperates with the outer wall surface of the sealing cover 16 to form the annular adhesive groove 161, and the sealing glue 14 is then filled into thie annular adhesive groove 161, which effectively seals the gap between the sealing cover 16 and the main housing 15, thus significantly enhancing the sealing and connection stability between the sealing cover 16 and the main housing 15. Furthermore, the arrangement of the annular adhesive groove 161 reduces the likelihood of the overflow of the sealing glue 14 and allows the filling process to be carried out in a visible environment during assembly, thus reducing assembly difficulty and increasing assembly efficiency and yield rate.

Optionally, as shown in FIG. 17, the sealing cover 16 includes a main cover body 162 and an annular flange 163 protruding from an outer wall surface of the main cover body 162. The annular flange 163 is supported on an annular support platform 153, and the inner wall surface of the main housing 15 located at a side of the annular support platform 153 facing the open end 152 cooperates with the outer wall surface of the main cover body 162 to form the annular adhesive groove 161.

By providing the sealing cover 16 that includes the main cover body 162 and the annular flange 163, and setting the annular flange 163 to be supported on the annular support platform 153, the installation and positioning of the sealing cover 16 are facilitated, and the connection stability and reliability between the sealing cover 16 and the main housing 15 can be enhanced.

Optionally, as shown in FIG. 16, the earphone 100 further comprises an elastic covering layer 18 covering an outer side of the main housing 15, wherein a portion of the main housing 15 is exposed from the elastic covering layer 18, and the decorative cover 17 further covers an outer side of the exposed portion of the main housing 15 and is connected to the exposed portion of the main housing 15.

By providing the elastic covering layer 18 on the outer side of the main housing 15, the wearing comfort of the earphone 100 can be effectively enhanced, thereby effectively enhancing user experience. A portion of the main housing 15 is exposed from the elastic covering layer 18 to connected with the decorative cover 17, facilitating the installation and positioning of the decorative cover 17 and effectively improving the stability and reliability of the connection between the decorative cover 17 and the main housing 15.

Optionally, as shown in FIG. 16, the main housing 15 includes a first main side wall 154, a second main side wall 155, a first auxiliary side wall 156, and a second auxiliary side wall 157. The first main side wall 154 and the second main side wall 155 are spaced apart from each other, the first auxiliary side wall 156 and the second auxiliary side wall 157 are connected to the first main side wall 154 and the second main side wall 155, and are spaced apart from each other. A portion of an outer wall surface of the first main side wall 154 and a portion of an outer wall surface of the second main side wall 155 are exposed from the elastic covering layer 18, and the decorative cover 17 covers an outer side of the exposed portion of the outer wall surface of the first main side wall 154 and an outer side of the exposed portion of the outer wall surface of the second main side wall 155.

By setting the decorative cover 17 on the outer side of the exposed portion of the outer wall surface of the first main side wall 154 and the outer side of the exposed portion of the outer wall surface of the second main side wall 155, it is easy to install and position the decorative cover 17, which is conducive to reducing the assembly difficulty of the earphone 100, and improving the assembly efficiency and yield rate of the earphone 100.

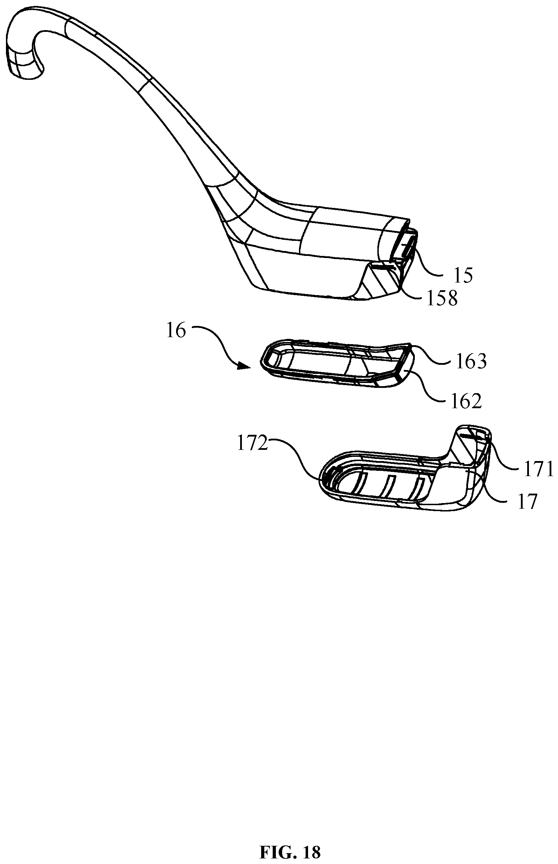

Optionally, as shown in FIG. 16 and FIG. 18, a first snap structure 158 is disposed on each of the exposed portion of the outer wall surface of the first main side wall 154 and the exposed portion of the outer wall surface of the second main side wall 155, and a second snap structure 171 corresponding to each first snap structure 158 is provided on an inner wall surface of the decorative cover 17.

By providing the first snap structure 158 on each of the exposed portion of the outer wall surface of the first main side wall 154 and the exposed portion of the outer wall surface of the second main side wall 155, and providing the second snap structure 171 corresponding to each first snap structure 158 on the inner wall surface of the decorative cover 17, a snap connection between the main housing 15 and the decorative cover 17 is achieved, thereby effectively enhancing the stability and reliability of the connection between the decorative cover 17 and the main housing 15.

Optionally, the thickness of a portion of the elastic covering layer 18 covering the outer wall surface of the first main side wall 154 and the thickness of a portion of the elastic covering layer 18 covering the outer wall surface of the second main side wall 155 are the same as the thickness of the decorative cover 17.

By setting the thickness of a portion of the elastic covering layer 18 covering the outer wall surface of the first main side wall 154 and the thickness of a portion of the elastic covering layer 18 covering the outer wall surface of the second main side wall 155 to be the same as the thickness of the decorative cover 17, a smooth connection between the outer surface of the decorative cover 17 and the outer surface of the elastic covering layer 18 can be achieved when the decorative cover 17 is connected to the main housing 15, thereby effectively enhancing the aesthetics and wearing comfort of the earphone 100, and enhancing user experience.

Optionally, as shown in FIG. 16, the earphone 100 further includes an ear hook 2 located at a side of the first auxiliary side wall 156 and connected to the main housing 15, and a rear hook 3 located at a side of the second auxiliary side wall 157 and connected to the main housing 15. The elastic covering layer 18 further covers the ear hook 2 and an outer side of the first auxiliary side wall 156, and the exposed portion of the outer wall surface of the first main side wall 154 and the exposed portion of the outer wall surface of the second main side wall 155 are closer to the second auxiliary side wall 157 than the first auxiliary side wall 156. Optionally, in some embodiments, the ear hook assembly 12 includes the main housing 15, the sealing cover 16, the decorative cover 17, and the ear hook 2.

By configuring the elastic covering layer 18 to further cover the ear hook 2 and the outer side of the first auxiliary side wall 156, the wearing comfort of the earphone 100 can be effectively enhanced, thereby effectively enhancing user experience.

Optionally, as shown in FIG. 16 and FIG. 18, a third snap structure 159 and a fourth snap structure 172 corresponding to each other are disposed on the first auxiliary side wall 156 and the decorative cover 17, respectively.

By arranging the third snap structure 159 and the fourth snap structure 172 corresponding to each other on the first auxiliary side wall 156 and the decorative cover 17, respectively, the snap connection between the main housing 15 and the decorative cover 17 is achieved, thereby effectively enhancing the connecting stability and reliability between the decorative cover 17 and the main housing 15.

Optionally, as shown in FIG. 16, the second auxiliary side wall 157 is exposed from the elastic covering layer 18, and the decorative cover 17 further covers an outer side of the second auxiliary side wall 157.

By exposing the second auxiliary side wall 157 from the elastic covering layer 18 and configuring the decorative cover 17 to further cover the outer side of the second auxiliary side wall 157, the positioning and installation of the decorative cover 17 are facilitated, and a contact area between the decorative cover 17 and the main housing 15 is increased, thereby enhancing the connection stability and reliability between the decorative cover 17 and the main housing 15, and improving the aesthetics of the earphone 100.

The above descriptions are merely part of the embodiments of the present disclosure and should not be construed as limiting the scope of protection of the present disclosure. Any equivalent devices or processes derived from the content of the present disclosure and the accompanying drawings, or directly or indirectly applied to other related technical fields, shall also be included within the scope of protection of the present disclosure.

## Claims

1. An earphone, comprising:
a housing assembly provided with a first accommodating cavity and including a connecting portion, the connecting portion being provided with a socket extending along a first direction, the socket including a first channel and a second channel, wherein the first accommodating cavity, the first channel, and the second channel are sequentially connected, and a first abutment surface is disposed at a transition between the first channel and the second channel, the first abutment surface being inclined to the first direction;
a speaker disposed in the first accommodating cavity; and
an ear hook assembly including a first connecting end, wherein the first connecting end includes a plug portion, the plug portion is inserted into the socket and includes a second abutment surface and an annular surface, the second abutment surface is inclined to the first direction, the annular surface extends from an inner edge of the second abutment surface toward the first abutment surface, and the second abutment surface is disposed to face the first abutment surface.

2. The earphone of claim 1, wherein
the plug portion includes a plug main body portion and a first convex platform extending from the plug main body portion toward the first abutment surface, the plug main body portion includes the second abutment surface, and the first convex platform includes the annular surface; and
the first convex platform further includes a third abutment surface inclined to the first direction, the third abutment surface being abutted against the first abutment surface.

3. The earphone of claim 1, wherein the first connecting end further includes a buckle portion, the buckle portion extending from the plug portion into the first accommodating cavity and engaging with the housing assembly for buckle fit.

4. The earphone of claim 3, wherein the buckle portion includes an elastic arm and a locking block, the elastic arm extends from the plug portion and is located within the first channel, the locking block is positioned at an end of the elastic arm and extends laterally with respect to the elastic arm, and the locking block engages with a wall surface of the first accommodating cavity for blocking fit.

5. The earphone of claim 4, wherein there are two elastic arms and two locking blocks, and the two locking blocks extend away from each other.

6. The earphone of claim 1, wherein the first abutment surface includes a portion perpendicular to the first direction; and/or the second abutment surface includes a portion perpendicular to the first direction.

7. The earphone of claim 1, wherein the annular surface extends in a direction parallel to the first direction toward the first abutment surface.

8. The earphone of claim 1, wherein the ear hook assembly is provided with a through-hole, and at least one of a reinforcement member and a wire is inserted into the through-hole.

9. The earphone of claim 1, further comprising a flexible member, the flexible member being disposed on a periphery of the annular surface and positioned between the second abutment surface and the first abutment surface.

10. The earphone of any one of claims 1 to 9, wherein the speaker is a bone conduction speaker.

11. The earphone of claim 10, wherein the housing assembly is further configured with a second accommodating cavity, and the earphone further comprises an air conduction speaker disposed in the second accommodating cavity.

12. The earphone of claim 11, wherein the housing assembly is provided with a pressure relief hole for communicating the second accommodating cavity with an external environment, and the pressure relief hole is configured to extend towards a side where the first accommodating cavity is located.

13. The earphone of claim 1, further comprising a button assembly, wherein
the button assembly includes a bracket and a button body;
the bracket is provided with a hole and an embedding slot located at a periphery of the hole and in communication with the hole; and
the button body is disposed on the bracket and includes a main body portion and an embedding portion connected to the main body portion, wherein the main body portion covers the hole, and the embedding portion is embedded in the embedding slot.

14. The earphone of claim 13, wherein there are multiple embedding slots and multiple embedding portions, and the multiple embedding slots and the multiple embedding portions are arranged at intervals around the hole.

15. The earphone of claim 13, wherein the bracket includes a plate-shaped portion having a first main surface and a second main surface that are arranged away from each other, the hole and the embedding slot penetrate through the plate-shaped portion along a direction of an interval between the first main surface and the second main surface.

16. The earphone of claim 15, wherein the main body portion is affixed to the first main surface, and the embedding portion is located on a side surface of the main body portion that is in contact with the first main surface.

17. The earphone of claim 16, wherein when viewed from a side of the first main surface, the main body portion further covers the embedding slot.

18. The earphone of claim 16, wherein the button body further includes a button reinforcement portion connected to the embedding portion, the button reinforcement portion being affixed to the second main surface.

19. The earphone of claim 15, wherein when viewed from a side of the first main surface and/or a side of the second main surface, a slot width of the embedding slot gradually increases in a direction away from the hole.

20. The earphone of claim 15, wherein along the direction of the interval between the first main surface and the second main surface, a slot width of the embedding slot changes with a depth of the embedding slot.

21. The earphone of claim 16, wherein the bracket further includes a bracket reinforcement portion disposed on the first main surface and/or the second main surface and located at a periphery of the hole and the embedding slot.

22. The earphone of claim 21, wherein the bracket reinforcement portion is arranged around the periphery of the hole and the embedding slot.

23. The earphone of any one of claims 13-22, wherein a material of the bracket and a material of the button body are a thermoplastic material, a Shore hardness of the button body is less than a Shore hardness of the bracket, and the button body is disposed on the bracket by molding.

24. The earphone of claim 1, further comprising a main housing, a sealing cover, and a decorative cover, wherein
the main housing is configured to form an accommodating space with at least one open end;
the sealing cover is configured to cover the at least one open end and is in sealing cooperation with the main housing; and
the decorative cover is connected to the main housing and covers an exterior of the sealing cover.

25. The earphone of claim 24, wherein the sealing cover and the main housing cooperate with each other to form an annular adhesive groove at a periphery of the sealing cover, and the earphone further comprises a sealing glue filled in the annular adhesive groove.

26. The earphone of claim 25, wherein an annular support platform is disposed on an inner wall surface of the main housing,
the sealing cover is supported on the annular support platform, and
the inner wall surface of the main housing located at a side of the annular support platform facing the open end cooperates with an outer wall surface of the sealing cover to form the annular adhesive groove.

27. The earphone of claim 26, wherein the sealing cover includes a main cover body and an annular flange protruding from an outer wall surface of the main cover body, the annular flange is supported on the annular support platform, and the inner wall surface of the main housing located at the side of the annular support platform facing the open end cooperates with the outer wall surface of the main cover body to form the annular adhesive groove.

28. The earphone of claim 24, further comprising an elastic covering layer covering an outer side of the main housing, wherein a portion of the main housing is exposed from the elastic covering layer, and the decorative cover further covers an outer side of the exposed portion of the main housing and is connected to the exposed portion of the main housing.

29. The earphone of claim 28, wherein the main housing includes a first main side wall, a second main side wall, a first auxiliary side wall, and a second auxiliary side wall, wherein the first main side wall and the second main side wall are spaced apart from each other, the first auxiliary side wall and the second auxiliary side wall are connected to the first main side wall and the second main side wall, and are spaced apart from each other,
a portion of an outer wall surface of the first main side wall and a portion of an outer wall surface of the second main side wall are exposed from the elastic covering layer, and
the decorative cover covers an outer side of the exposed portion of the outer wall surface of the first main side wall and an outer side of the exposed portion of the outer wall surface of the second main side wall.

30. The earphone of claim 29, wherein
a first snap structure is disposed on each of the exposed portion of the outer wall surface of the first main side wall and the exposed portion of the outer wall surface of the second main side wall, and
a second snap structure corresponding to each first snap structure is provided on an inner wall surface of the decorative cover.

31. The earphone of claim 29, wherein a thickness of a portion of the elastic covering layer covering the outer wall surface of the first main side wall and a thickness of a portion of the elastic covering layer covering the outer wall surface of the second main side wall are the same as a thickness of the decorative cover.

32. The earphone of claim 29, further comprising an ear hook located at a side of the first auxiliary side wall and connected to the main housing, and a rear hook located at a side of the second auxiliary side wall and connected to the main housing,
the elastic covering layer further covers the ear hook and an outer side of the first auxiliary side wall, and
the exposed portion of the outer wall surface of the first main side wall and the exposed portion of the outer wall surface of the second main side wall are closer to the second auxiliary side wall than the first auxiliary side wall.

33. The earphone of claim 32, wherein a third snap structure and a fourth snap structure corresponding to each other are disposed on the first auxiliary side wall and the decorative cover, respectively.

34. The earphone of claim 31, wherein the second auxiliary side wall is exposed from the elastic covering layer, and the decorative cover further covers an outer side of the second auxiliary side wall.
